(19) Europäisches Patentamt
European Patent Office
Office européen des brevets

(11) **EP 4 184 590 B1**

(12) **EUROPEAN PATENT SPECIFICATION**

(45) Date of publication and mention
of the grant of the patent:
**21.08.2024  Bulletin 2024/34**

(21) Application number: **22206301.8**

(22) Date of filing: **09.11.2022**

(51) International Patent Classification (IPC):
*H01L 29/78* (2006.01)     *H01L 29/06* (2006.01)
*H01L 29/10* (2006.01)     *H01L 29/40* (2006.01)

(52) Cooperative Patent Classification (CPC):
**H01L 29/7835; H01L 29/063; H01L 29/1083;
H01L 29/404;** H01L 29/0653

(54) **SEMICONDUCTOR DEVICE**

HALBLEITERANORDNUNG

DISPOSITIF SEMI-CONDUCTEUR

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **18.11.2021   JP 2021187723**

(43) Date of publication of application:
**24.05.2023   Bulletin 2023/21**

(73) Proprietor: **ABLIC Inc.
Kitasaku-gun, Nagano 389-0293 (JP)**

(72) Inventor: **WADA, Shinichirou
100-8280 Tokyo (JP)**

(74) Representative: **Novagraaf Group
Chemin de l'Echo 3
1213 Onex / Geneva (CH)**

(56) References cited:
**EP-A1- 3 901 993     US-A1- 2017 222 042**

**Description**

BACKGROUND

Technical Field

The present invention relates to the structure of a semiconductor device, and more particularly relates to a technique effectively applied to a high breakdown voltage LDMOS transistor which requires a high breakdown voltage of 100V or higher.

Description of Related Art

There is an LDMOS (Lateral Double-diffused MOS) transistor with a breakdown voltage of about 30V or higher, which is formed on a semiconductor substrate, as the transistor used in drive circuits which use inductors, such as automotive solenoids and fan motors, and capacitive elements, such as piezoelectric elements, as the loads.

In order to realize low on-resistance while ensuring a high breakdown voltage in this LDMOS transistor, a transistor structure is known in which an impurity layer (buried layer) having an opposite conductivity type to the drift region is provided under the drift region while the impurity concentration of the drift region through which a current flows is increased (Patent Literature 1).

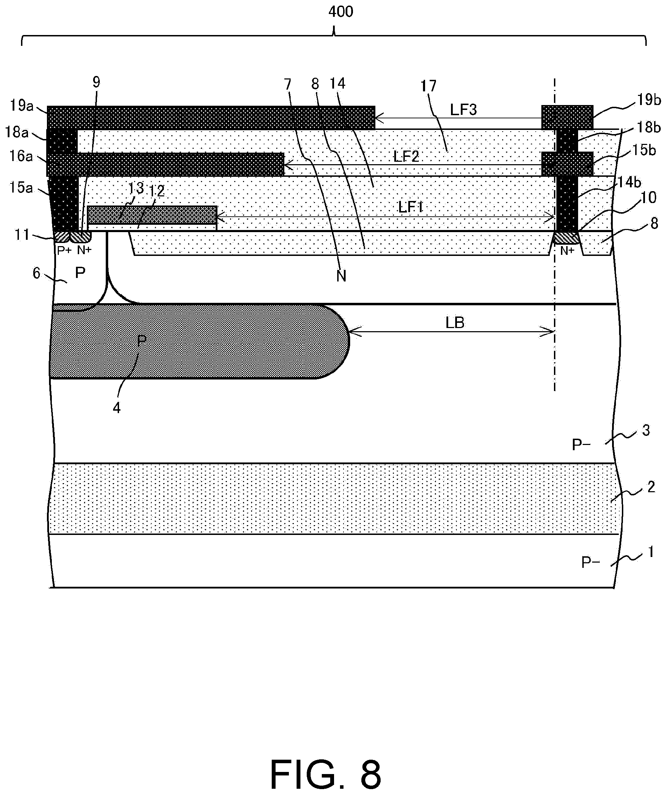

In the conventional N-type LDMOS transistor 400 illustrated in FIG. 8, a P-type buried layer 4 extends from a P-type body region to a position under an N-type drift region 7, and a first field plate of a gate electrode 13 is provided on an insulating layer 8 above the drift region 7 and second field plates 16a and 19a composed of a plurality of wiring layers are provided to be formed on interlayer insulating films 14 and 17 above the first field plate. Then, the distance LB from the drain 10 to the P-type buried layer 4 is designed to be smaller than the distance LF 1 from the drain to the first field plate and greater than the distance LF3 from the drain to the upper wiring layer 19a which constitutes the second field plate.

With such a configuration, even when the impurity concentration of the drift region 7 is set to a relatively high concentration of 1e16/cm$^3$ or more, the electric potential can be made uniform without causing concentration of the electric field in the drift region 7 in the off state of the transistor. As a result, it is possible to obtain transistor characteristics which achieve both a high breakdown voltage and low on-resistance.

Related Art

[Patent Literature 1] Japanese Patent Laid-Open No. 2020-98883

SUMMARY

Problems to be Solved

However, in the N-type LDMOS transistor described in the above-mentioned Patent Literature 1, although a relatively high breakdown voltage can be obtained in the off state, there is a characteristic that the current increases as the source-drain voltage (Vds) increases without saturating in the saturation region of the drain current when the transistor is in the on state.

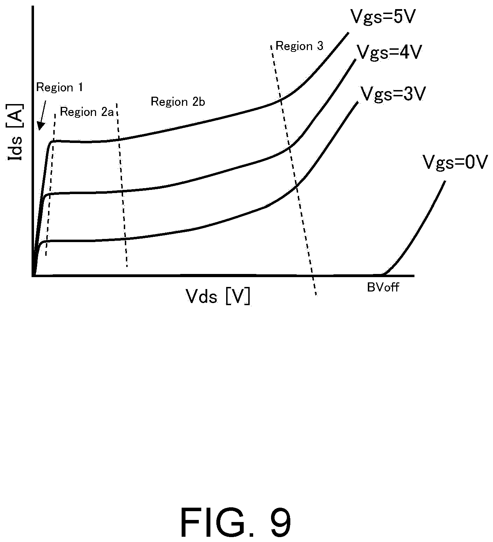

FIG. 9 illustrates the Vds dependence of the drain current (Ids) in the on/off state of the N-type LDMOS transistor illustrated in FIG. 8. In the on state in which a voltage is applied to the gate, the drain current is divided into a linear region (Region 1) where Ids changes linearly with respect to Vds, a saturation region (Region 2) where the change of Ids is small with respect to Vds, and an avalanche region (Region 3) where Ids changes greatly with respect to Vds, and in the saturation region (Region 2), there is a region (Region 2b) where Vds gradually increases as Vds increases. This region arises from a relatively low Vds with respect to the voltage of the off breakdown voltage (BVoff). When a transistor with such characteristics is used in a current mirror circuit, the mirror ratio changes depending on the amount of current.

In addition, in this transistor, as illustrated in FIG. 9, the Vds, which is the avalanche region (Region 3) where Ids changes greatly with respect to Vds, is also relatively small with respect to BVoff.

Therefore, for example, in a drive circuit which uses an inductor as the load, when a high Vds is applied during a transition period from the off state to the on state and the transistor enters the avalanche region (Region 3), there is a problem that a large drain current flows and destroys the element.

Furthermore, in the drive circuit using this transistor, when the operating condition is to transition through the saturation region of Region 2b during the switching operation, reliability issues arise as the characteristics of the transistor change over time.

Thus, an object of the present invention is to provide a high-performance high breakdown voltage LDMOS field effect transistor capable of achieving both a high breakdown voltage and low on-resistance in high breakdown voltage LDMOS field effect transistor.

Specifically, an object of the present invention is to provide a transistor having the current characteristics that the source-drain voltage dependence of the drain current is small in the saturation region of the drain current of the high breakdown voltage LDMOS transistor having characteristics of off breakdown voltage and low on-resistance.

Further, another object of the present invention is to provide a transistor having the characteristics that the source-drain voltage at which the drain current starts to increase rapidly is large in the avalanche region of the drain current of the high breakdown voltage LDMOS transistor having characteristics of off breakdown voltage and low on-resistance.

Further, another object of the present invention is to provide a transistor having high reliability characteristics that the change over time of the characteristics such as on-resistance is small.

Means for Solving the Problems

In order to solve the above problems, an embodiment of the present invention includes a body region of a first conductivity type formed on a main surface of a semiconductor substrate; a source region of a second conductivity type formed on a surface of the body region; a drift region of the second conductivity type formed to be in contact with the body region; a drain region of the second conductivity type formed on the drift region; a gate electrode formed on the body region between the source region and the drift region and the drift region on the side of the source region via a gate insulating film; a first field plate extending from the gate electrode towards the drain region and formed on the drift region via a first insulating film; a second field plate composed of a plurality of wiring layers, and being in contact with the source region or the gate electrode and formed on the first field plate via a second insulating film; a first buried region of the first conductivity type being in contact with the body region and formed under the drift region; and a second buried region of the first conductivity type being adjacent to the first buried region and having an impurity concentration smaller than an impurity concentration of the first buried region formed under the drift region and extending from the first buried region towards the drain region. In the plurality of wiring layers constituting the second field plate, a distance between an upper wiring layer and the drain region is shorter than a distance between a lower wiring layer and the drain region, and a distance between a lowermost wiring layer and the drain region is shorter than a distance between the first field plate and the drain region, a distance between an uppermost wiring layer and the drain region is shorter than a distance between the second buried region and the drain region, and the distance between the first field plate and the drain region is longer than a distance between the first buried region and the drain region.

Effects

According to the present invention, it is possible to realize a high-performance high breakdown voltage LDMOS field effect transistor capable of achieving both a high breakdown voltage and low on-resistance in high breakdown voltage LDMOS field effect transistor.

According to the present invention, it is possible to realize a transistor having the current characteristics that the source-drain voltage dependence of the drain current is small in the saturation region of the drain current of the LDMOS transistor having characteristics of off breakdown voltage and low on-resistance.

Further, according to the present invention, it is possible to realize a transistor having the characteristics of a large source-drain voltage of the avalanche region (Region 3) at which the drain current of the LDMOS transistor having characteristics of off breakdown voltage and low on-resistance starts to increase rapidly.

Further, according to the present invention, it is possible to realize a transistor having high reliability characteristics that the change over time of the transistor characteristics such as on-resistance is small.

Problems, configurations, and effects other than those described above will be clarified by the following description of the embodiments.

BRIEF DESCRIPTION OF THE DRAWINGS

FIG. 1 is a diagram illustrating the cross-sectional structure of the semiconductor device according to the first embodiment of the present invention.

FIG. 2 is a diagram illustrating the impurity concentration distribution in the direction parallel to the substrate main plane along the broken line A-A' of the semiconductor device of FIG. 1.

FIG. 3 is a diagram illustrating the drain current characteristics of the conventional semiconductor device.

FIG. 4 is a diagram illustrating the equipotential distribution in the on state of the semiconductor device according to the first embodiment of the present invention.

FIG. 5 is a diagram illustrating the cross-sectional structure of the semiconductor device according to the second embodiment of the present invention.

FIG. 6 is a diagram illustrating the cross-sectional structure of the semiconductor device according to the third embodiment of the present invention.

FIG. 7 is a diagram illustrating the impurity concentration distribution in the direction parallel to the substrate main plane along the broken line B-B' of the semiconductor device of FIG. 6.

FIG. 8 is a diagram illustrating the cross-sectional structure of the conventional semiconductor device.

FIG. 9 is a diagram illustrating the drain current characteristics of the conventional semiconductor device.

FIG. 10 is a diagram illustrating the equipotential distribution in the on state of the conventional semiconductor device.

DESCRIPTION OF THE EMBODIMENTS

Embodiments of the present invention will be described below with reference to the drawings. In addition, in each drawing, the same configurations are denoted by the same reference numerals, and detailed descriptions of the repeated parts will be omitted.

[Embodiment 1]

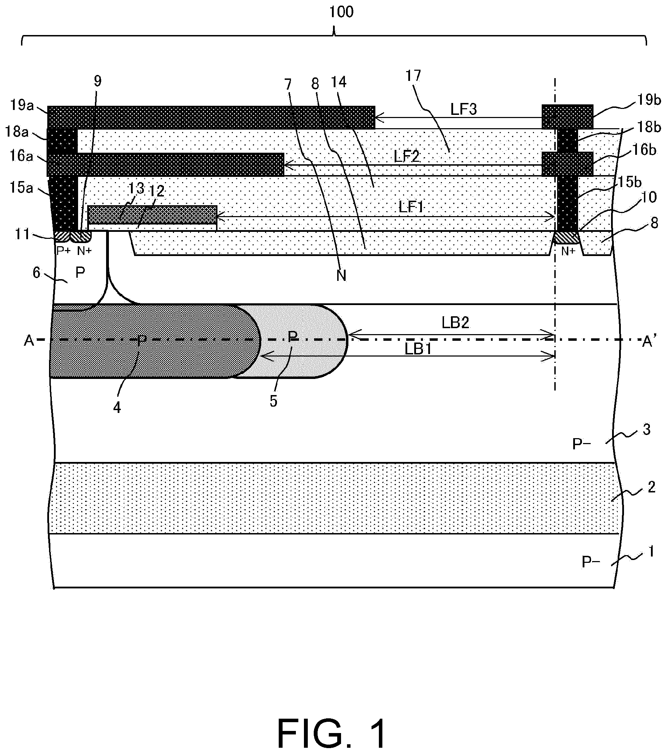

The semiconductor device according to the first embodiment of the present invention will be described with reference to FIG. 1 to FIG. 4.

As illustrated in FIG. 1, the semiconductor device of this embodiment is an N-type LDMOS transistor 100, and is formed on an SOI semiconductor substrate in which an insulating layer 2 is formed on a P-type semiconductor substrate 1 and a P-type semiconductor layer 3 is formed on the insulating layer 2.

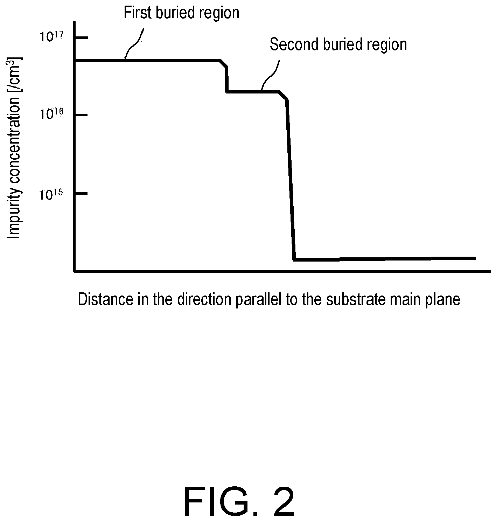

In the SOI semiconductor substrate, a P-type semiconductor layer having an impurity concentration of $4e16/cm^3$, for example, which becomes a first buried region 4, is formed to be connected to a P body region 6 of a P-type semiconductor layer formed on the SOI semiconductor substrate, and a P-type semiconductor layer, which becomes a second buried region 5, is adjacent to the first buried region 4 in a direction parallel to the substrate main plane. FIG. 2 illustrates the impurity concentration distribution in the direction parallel to the substrate main plane along the broken line A-A' in FIG. 1. The impurity concentration of the second buried region 5 is, for example, $2e16/cm^3$ and is set to be in the range of 1/3 to 2/3 with respect to the impurity concentration of the first buried region 4.

Further, a drift region 7 composed of an N-type semiconductor layer having an impurity concentration of $5e16/cm^3$, for example, is formed adjacent to the P body region 6 and above the first buried region 4 and the second buried region 5, and a source region 9 of an N-type semiconductor layer and a P body connection region 11 are formed on a surface of the P body region 6. Besides, an N-type drain region 10 is formed on the N-type drift region 7. Then, a gate oxide film 12 composed of an insulating layer is formed on the SOI semiconductor substrate to be adjacent to the source region 9, and a gate electrode 13 composed of N-type polysilicon is formed on a portion of the P body region 6 and a portion of the drift region 7 on the side of the source region 9 via the gate oxide film 12.

Further, an STI (Shallow Trench Isolation) composed of an insulating layer 8 is formed on the drift region 7, and the gate electrode 13 extends over a portion of the STI and constitutes a first field plate 13.

Subsequently, an interlayer insulating film 14 is deposited on the SOI semiconductor substrate, and a portion thereof is perforated so that a contact 15a composed of a metal layer such as aluminum (Al) is formed on the source region 9 and the P body connection region 11, and a contact 15b is formed on the drain region 10.

Then, first wiring layers 16a and 16b composed of a metal layer such as aluminum (Al) are formed on the interlayer insulating film 14 and connected to the contacts 15a and 15b, respectively. The first wiring layer 16a connected to the contact 15a constitutes a source electrode and extends in the direction of the drain region to constitute a second field plate.

Furthermore, an interlayer insulating film 17 is deposited on the first wiring layers 16a and 16b, and a portion thereof is perforated so that wiring connection holes 18a and 18b composed of a metal layer such as aluminum (Al) are formed on the first wiring layers 16a and 16b, respectively. Then, second wiring layers 19a and 19b composed of a metal layer such as aluminum (Al) are formed on the interlayer insulating film 17 and connected to the wiring connection holes 18a and 18b, respectively. The second wiring layer 19a connected to the wiring connection hole 18a constitutes the source electrode and extends in the direction of the drain region to constitute the second field plate.

Here, as illustrated in FIG. 1, when the distance in the semiconductor substrate plane direction between the first field plate 13 and the drain region 10 is LF1, the distance in the semiconductor substrate plane direction between the second field plate 16a composed of the first wiring layer and the drain region 10 is LF2, and the distance in the semiconductor substrate plane direction between the second field plate 19a composed of the second wiring layer and the drain region 10 is LF3, LF 1, LF2, and LF3 have the relationship of Formula (1).
[Formula 1]

$$LF1 > LF2 > LF3 \ldots (1)$$

That is, the distances of the first and second field plates (13, 16a, 19a) from the drain region 10 in the semiconductor substrate plane direction decrease toward the upper layers.

Further, when the distance in the semiconductor substrate plane direction between the first buried region 4 and the drain region 10 is LB1, and the distance in the semiconductor substrate plane direction between the second buried region 5 and the drain region 10 is LB2, LB1, LB2, LF1, and LF3 have the relationships of Formulas (2) and (3).
[Formula 2]

$$LF1 > LB1 \ldots (2)$$

[Formula 3]

$$LB2 > LF3 \ldots (3)$$

That is, the distances LB1 and LB2 between the first and second buried regions (4, 5) and the drain region 10 are smaller than the distance LF 1 between the first field plate 13 and the drain region 10, and greater than the distance LF3 between the second field plate 19a of the wiring in the uppermost layer and the drain region 10.

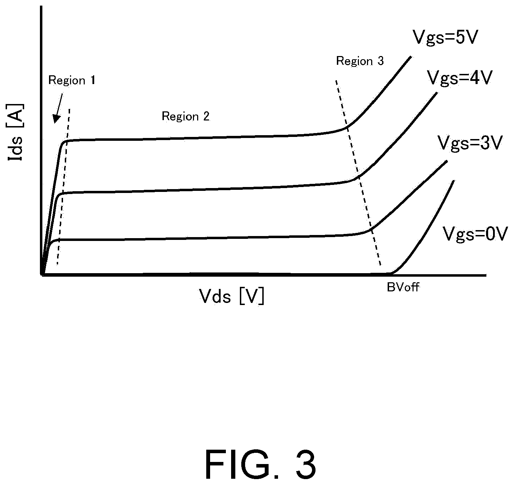

With such a configuration, the saturation current characteristics when the transistor 100 is in the on state are as illustrated in FIG. 3, and the Vds dependence of the drain current (Ids) in the saturation region (Region 2) can be reduced. In addition, the Vds voltage, which is the avalanche region (Region 3) where Ids greatly increases with Vds, can be set to a value close to the off breakdown voltage (BVoff).

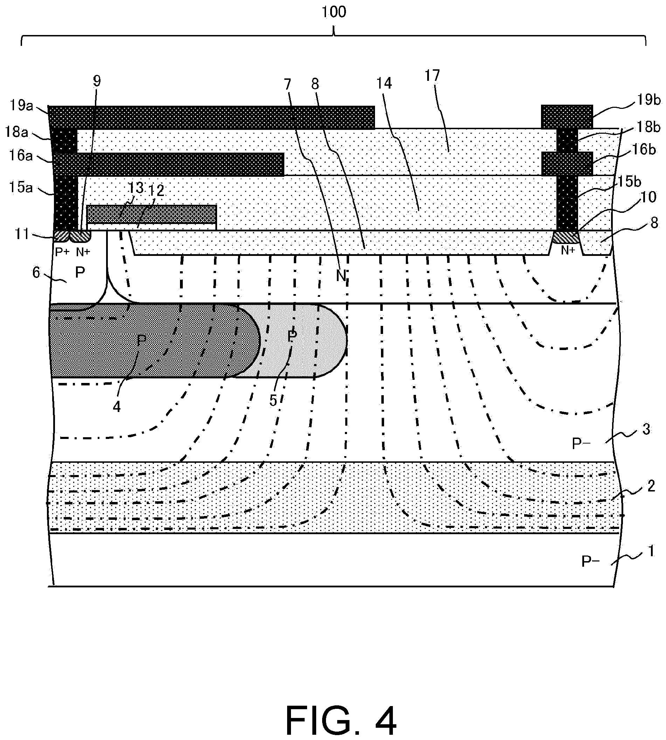

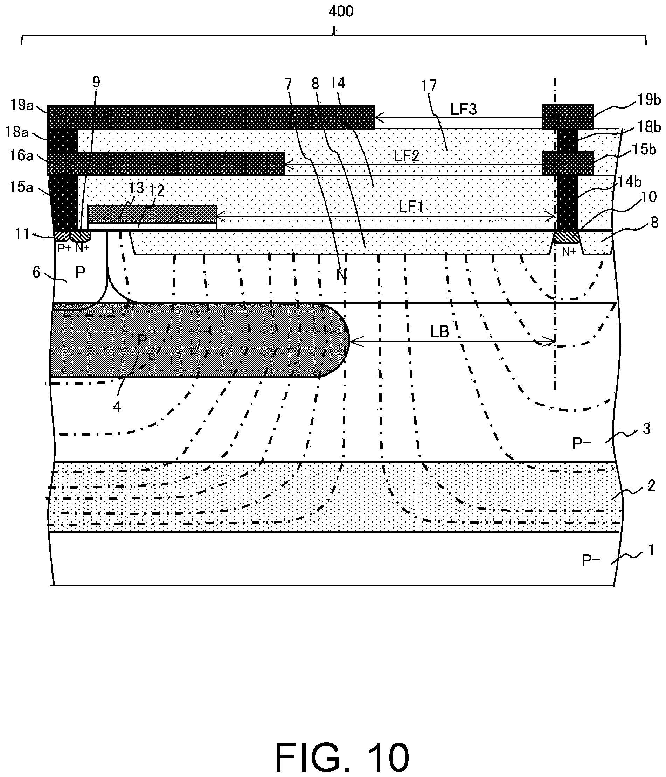

Next, the reason why such characteristics are obtained will be described. FIG. 4 illustrates the electric potential distribution when 5 V is applied between the gate and the source of the transistor 100 and a relatively high voltage (Vds) of 300 V is applied between the source and the drain so that the drain current is in the saturation region (Region 2). Although the impurity concentration of the drift region 7 is relatively high at $5e16/cm^3$, due to the resurf effect of the first field plate 13, the second field plate (16a, 19a), and the first and second buried layers (4, 5), the electric potential of the drift region 7 is distributed without the electric field being locally concentrated. Further, in the transistor 400 having the conventional structure of FIG. 8, as illustrated in FIG. 10, the electric potential of the buried layer 4 is not uniform, and the electric field concentrates in the direction close to the drain region 10, whereas the electric potential is uniformly distributed in the first buried layer 4 and the second buried layer 5, and electric field concentration is suppressed. Therefore, as a result of suppressing the avalanche current due to the impact ionization phenomenon, the Vds dependence of the drain current (Ids) in the saturation region (Region 2) can be reduced, and the Vds at which the avalanche region (Region 3) starts can be increased.

In order to make the electric potential in the drift region 7 more uniform and obtain a higher breakdown voltage, it is more desirable to have the relationship given by Formula (4), but the present invention is not limited thereto.
[Formula 4]

$$LB1 > LF2 > LB2 \ldots (4)$$

Although the second field plate 16a is electrically connected to the N-type source region 9 (body region 6) in this embodiment, a similar effect can be obtained when the second field plate 16a is electrically connected to the gate electrode and the first field plate 13.

In addition, although this embodiment illustrates an example of an N-type MOS transistor, a similar effect can be obtained with a P-type MOS transistor.

Furthermore, even if a PN junction structure is provided in the N-type drain region 10 of the N-type MOS transistor to form an IGBT structure, by suppressing the electric field concentration in the drift region, it is possible to increase the breakdown voltage while downsizing the element. In this case, in the structure illustrated in FIG. 1, the N-type source region 9 becomes the "emitter region" and the N-type drain region 10 becomes the "collector region."

[Embodiment 2]

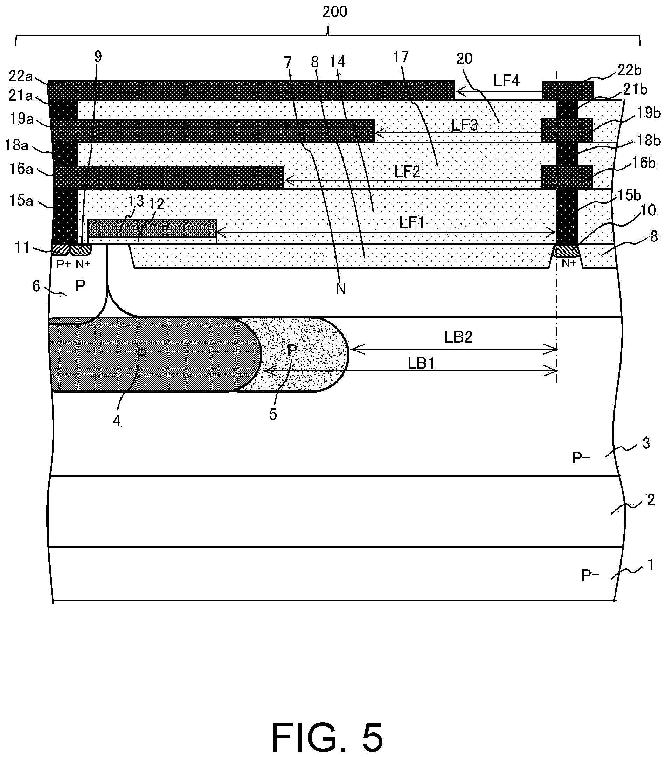

The semiconductor device according to the second embodiment of the present invention will be described with reference to FIG. 5, mainly focusing on the difference from the first embodiment.

The difference from the first embodiment is that the N-type LDMOS transistor 200 has an interlayer insulating film 20 deposited on the second wiring layers (19a, 19b), wiring connection holes (21a, 21b) perforated in the interlayer insulating film 20 are connected to the second wiring layers (19a, 19b), and third wiring layers (22a, 22b) are formed on the interlayer insulating film 20. The third wiring layer 22a which becomes the source electrode extends in the direction of the drain region 10 to constitute the second field plate.

Here, as illustrated in FIG. 5, when the distance in the semiconductor substrate plane direction between the second field plate 22a composed of the third wiring and the drain region 10 is LF4, LF1, LF2, LF3, and LF4 have the relationship of Formula (5).

[Formula 5]

$$LF1 > LF2 > LF3 > LF4 \ldots (5)$$

That is, the distances of the first field plate 13 and the second field plates (16a, 19a, 22a) from the drain region 10 in the semiconductor substrate plane direction decrease toward the upper layers.

Further, LF1, LB1, LB2, and LF4 have the relationships of Formulas (2) and (6).

[Formula 2]

$$LF1 > LB1 \ldots (2)$$

[Formula 6]

$$LB2 > LF4 \ldots (6)$$

That is, the distances LB1 and LB2 between the first and second buried regions (4, 5) and the drain region 10 are smaller than the distance LF 1 between the first field plate 13 and the drain 10, and greater than the distance LF4 between the second field plate 22a of the wiring in the uppermost layer and the drain region 10.

With such a configuration, the electric potential distribution in the drift region 7 can be made more uniform than in the transistor 100 of the first embodiment, and in the transistor with a higher breakdown voltage, as illustrated in FIG. 3, it is possible to obtain saturation current characteristics that the Vds dependence of the drain current (Ids) is small.

[Embodiment 3]

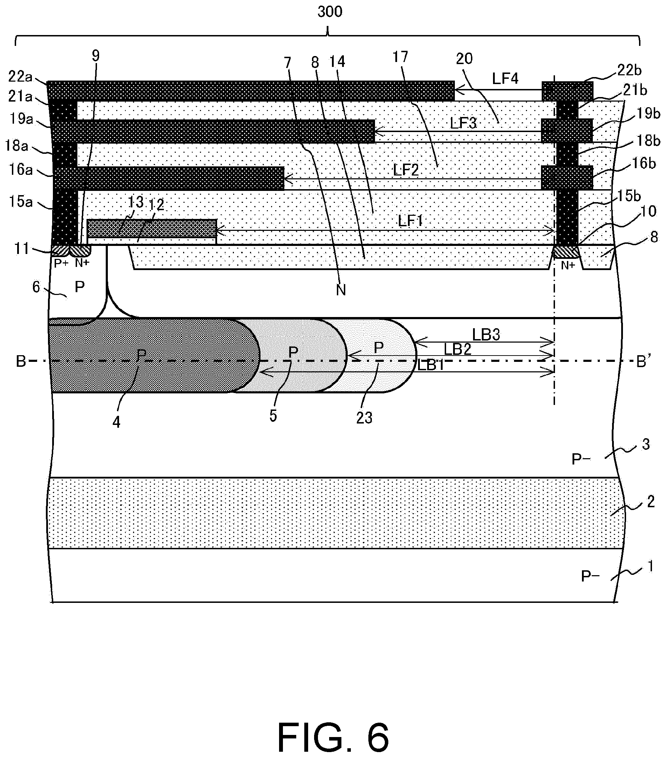

The semiconductor device according to the third embodiment of the present invention will be described with reference to FIG. 6, mainly focusing on the difference from the second embodiment.

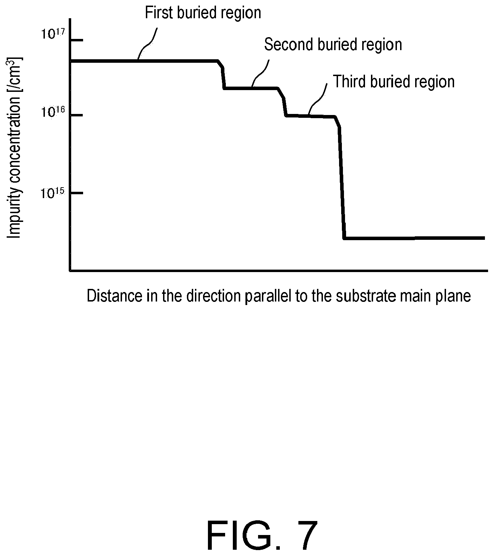

The difference from the second embodiment is that, in the N-type LDMOS transistor 300, a third buried region 23 composed of a P-type semiconductor layer is provided in the semiconductor substrate to be adjacent to the second buried region 5 and under the drift region 7. FIG. 7 illustrates the impurity concentration distribution in the direction parallel to the substrate main plane along the broken line B-B' in FIG. 6, but the impurity concentration of the third buried region 23 is, for example, $1e16/cm^3$, which is about 1/3 to 2/3 with respect to the impurity concentration of the second buried region 5.

Further, as illustrated in FIG. 6, when the distance in the semiconductor substrate plane direction between the third buried region 23 and the drain region 10 is LB3, LB1, LB3, LF1, and LF4 have the relationships of Formulas (2) and (7).

[Formula 2]

$$LF1 > LB1 \ldots (2)$$

[Formula 7]

$$LB3 > LF4 \ldots (7)$$

With such a configuration, the electric potential distribution in the buried regions (4, 5, 23) can be made more uniform than in the transistor 200 of the second embodiment, and in the transistor with a high breakdown voltage, it is possible to obtain saturation current characteristics that the Vds dependence of the drain current (Ids) is smaller.

In order to make the electric potential in the drift region 7 more uniform and obtain a higher breakdown voltage, it is desirable to have the relationship given by Formula (8), but the present invention is not limited thereto.

[Formula 8]

$$LB1 > LF2 > LB2 > LF3 > LB3 > LF4 \ldots (8)$$

In addition, the present invention is not limited to the above-described embodiments, and includes various modifications. For example, the above-described embodiments have been described in detail in order to explain the present invention to be easily understandable, and are not necessarily limited to those having all the described configurations. In addition, it is possible to replace part of the configuration of one embodiment with the configuration of another embodiment, and it is also possible to add the configuration of another embodiment to the configuration of one embodiment. Moreover, it is possible to add, delete or replace part of the configuration of each embodiment with another configuration.

The scope of the present invention is defined by the appended claims.

Reference Signs List

1 ... P-type (semiconductor) substrate
2 ... Insulating layer
3 ... P-type semiconductor layer
4 ... First buried region
5 ... Second buried region
6 ... P body region
7 ... Drift region
8 ... STI
9 ... Source region
10 ... Drain region
11 ... P body connection region
12 ... Gate oxide film
13 ... Gate electrode (first field plate)
14 ... Interlayer insulating film
15a, 15b ... contact
16a ... First wiring layer (source electrode, second field plate)
16b ... First wiring layer (drain electrode)
17 ... Interlayer insulating film
18a, 18b ... Wiring connection hole
19a ... Second wiring layer (source electrode, second field plate)
19b ... Second wiring layer (drain electrode)
20 ... Interlayer insulating film
21a, 21b ... Wiring connection hole
22a ... Uppermost wiring layer (source electrode, second field plate)
22b ... Uppermost wiring layer (drain electrode)

23 ... Third buried region
100 ... N-type LDMOS transistor of the first embodiment
200 ... N-type LDMOS transistor of the second embodiment
300 ... N-type LDMOS transistor of the third embodiment
400 ... N-type LDMOS transistor having the conventional structure

**Claims**

1. A semiconductor device, comprising:

   a body region (6) of a first conductivity type formed on a main surface of a semiconductor substrate (1);
   a source region (9) of a second conductivity type formed on a surface of the body region;
   a drift region (7) of the second conductivity type formed to be in contact with the body region;
   a drain region (10) of the second conductivity type formed on the drift region;
   a gate electrode (13) formed on the body region between the source region and the drift region and the drift region on the side of the source region via a gate insulating film (12);
   a first field plate (13) extending from the gate electrode towards the drain region and formed on the drift region via a first insulating film (8);
   a second field plate (16a, 19a) composed of a plurality of wiring layers, and being in contact with the source region or the gate electrode and formed on the first field plate via a second insulating film (14);
   a first buried region (4) of the first conductivity type being in contact with the body region and formed under the drift region; and
   a second buried region (5) of the first conductivity type being adjacent to the first buried region and having an impurity concentration smaller than an impurity concentration of the first buried region formed under the drift region and extending from the first buried region towards the drain region,
   wherein in the plurality of wiring layers constituting the second field plate, a distance between an upper wiring layer and the drain region is shorter than a distance between a lower wiring layer and the drain region, and a distance between a lowermost wiring layer and the drain region is shorter than a distance between the first field plate and the drain region,
   a distance between an uppermost wiring layer and the drain region is shorter than a distance between the second buried region and the drain region, and
   the distance between the first field plate and the drain region is longer than a distance between the first buried region and the drain region.

2. The semiconductor device according to claim 1, wherein an impurity concentration of the drift region is greater than $1e10^{16}/cm^3$, and an impurity concentration of the first buried region is greater than $1e10^{16}/cm^3$, and
   the impurity concentration of the second buried region is set to a value of 1/3 to 2/3 of the impurity concentration of the first buried region.

3. The semiconductor device according to claim 1 or 2, wherein in the plurality of wiring layers constituting the second field plate,
   the distance between the lowermost wiring layer and the drain region is smaller than the distance between the first buried region and the drain region, and greater than the distance between the second buried region and the drain region.

4. The semiconductor device according to claim 3, comprising:

   a third buried region (23) of the first conductivity type being adjacent to the second buried region and having an impurity concentration smaller than the impurity concentration of the second buried region formed under the drift region and extending from the second buried region towards the drain region,
   wherein a distance between the third buried region and the drain region is greater than the distance between the uppermost wiring layer and the drain region in the wiring layers constituting the second field plate.

5. The semiconductor device according to claim 4, wherein the impurity concentration of the third buried region is set to a value of 1/3 to 2/3 of the impurity concentration of the second buried region.

6. The semiconductor device according to any one of claims 1 to 5, wherein the semiconductor substrate comprises an SOI substrate having a buried insulating layer in a semiconductor layer.

**Patentansprüche**

1. Halbleitervorrichtung, umfassend:

   einen Körperbereich (6) einer ersten Leitfähigkeitsart, der auf einer Hauptoberfläche eines Halbleitersubstrats (1) ausgebildet ist;
   einen Source-Bereich (9) einer zweiten Leitfähigkeitsart, der auf einer Oberfläche des Körperbereichs ausgebildet ist;
   einen Drift-Bereich (7) der zweiten Leitfähigkeitsart, der ausgebildet ist, um mit dem Körperbereich in Kontakt zu stehen;
   einen Drain-Bereich (10) der zweiten Leitfähigkeitsart, der auf dem Drift-Bereich ausgebildet ist;
   eine Gateelektrode (13), die auf dem Körperbereich zwischen dem Source-Bereich und dem Drift-Bereich und dem Drift-Bereich auf der Seite des Source-Bereichs über einen Gate-Isolierfilm (12) ausgebildet ist;
   eine erste Feldplatte (13), die sich von der Gateelektrode in Richtung des Drain-Bereichs erstreckt und über einen ersten Isolierfilm (8) auf dem Drift-Bereich ausgebildet ist;
   eine zweite Feldplatte (16a, 19a), die aus einer Vielzahl von Verdrahtungsschichten besteht und mit dem Source-Bereich oder der Gateelektrode in Kontakt steht und über einen zweiten Isolierfilm (14) auf der ersten Feldplatte ausgebildet ist;
   einen ersten vergrabenen Bereich (4) der ersten Leitfähigkeitsart, der mit dem Körperbereich in Kontakt steht und unter dem Drift-Bereich ausgebildet ist; und
   einen zweiten vergrabenen Bereich (5) der ersten Leitfähigkeitsart, der an den ersten vergrabenen Bereich angrenzt und eine geringere Störstellenkonzentration als eine Störstellenkonzentration des ersten vergrabenen Bereichs aufweist, der unter dem Drift-Bereich ausgebildet ist und sich von dem ersten vergrabenen Bereich in Richtung des Drain-Bereichs erstreckt,
   wobei in der Vielzahl von Verdrahtungsschichten, die die zweite Feldplatte bilden, ein Abstand zwischen einer oberen Verdrahtungsschicht und dem Drain-Bereich kürzer als ein Abstand zwischen einer unteren Verdrahtungsschicht und dem Drain-Bereich ist, und ein Abstand zwischen einer untersten Verdrahtungsschicht und dem Drain-Bereich kürzer als ein Abstand zwischen der ersten Feldplatte und dem Drain-Bereich ist,
   ein Abstand zwischen einer obersten Verdrahtungsschicht und dem Drain-Bereich kürzer als ein Abstand zwischen dem zweiten vergrabenen Bereich und dem Drain-Bereich ist und
   der Abstand zwischen der ersten Feldplatte und dem Drain-Bereich länger als ein Abstand zwischen dem ersten vergrabenen Bereich und dem Drain-Bereich ist.

2. Halbleitervorrichtung nach Anspruch 1, wobei eine Störstellenkonzentration des Drift-Bereichs größer als $1e10^{16}/cm^3$ ist und eine Störstellenkonzentration des ersten vergrabenen Bereichs größer als $1e10^{16}/cm^3$ ist und die Störstellenkonzentration des zweiten vergrabenen Bereichs auf einen Wert von 1/3 bis 2/3 der Störstellenkonzentration des ersten vergrabenen Bereichs eingestellt ist.

3. Halbleitervorrichtung nach Anspruch 1 oder 2, wobei in der Vielzahl von Verdrahtungsschichten, die die zweite Feldplatte bilden,
   der Abstand zwischen der untersten Verdrahtungsschicht und dem Drain-Bereich kleiner als der Abstand zwischen dem ersten vergrabenen Bereich und dem Drain-Bereich und größer als der Abstand zwischen dem zweiten vergrabenen Bereich und dem Drain-Bereich ist.

4. Halbleitervorrichtung nach Anspruch 3, umfassend:

   einen dritten vergrabenen Bereich (23) der ersten Leitfähigkeitsart, der an den zweiten vergrabenen Bereich angrenzt und eine geringere Störstellenkonzentration als die Störstellenkonzentration des zweiten vergrabenen Bereichs aufweist, der unter dem Drift-Bereich ausgebildet ist und sich von dem zweiten vergrabenen Bereich in Richtung des Drain-Bereichs erstreckt,
   wobei ein Abstand zwischen dem dritten vergrabenen Bereich und dem Drain-Bereich größer als der Abstand zwischen der obersten Verdrahtungsschicht und dem Drain-Bereich in den Verdrahtungsschichten, die die zweite Feldplatte bilden, ist.

5. Halbleitervorrichtung nach Anspruch 4, wobei die Störstellenkonzentration des dritten vergrabenen Bereichs auf einen Wert von 1/3 bis 2/3 der Störstellenkonzentration des zweiten vergrabenen Bereichs eingestellt ist.

**6.** Halbleitervorrichtung nach einem der Ansprüche 1 bis 5, wobei das Halbleitersubstrat ein SOI-Substrat, das eine vergrabene Isolierschicht in einer Halbleiterschicht aufweist, umfasst.

**Revendications**

**1.** Dispositif semi-conducteur, comprenant :

une région de corps (6) d'un premier type de conductivité formée sur une surface principale d'un substrat semi-conducteur (1) ;
une région de source (9) d'un second type de conductivité formée sur une surface de la région de corps ;
une région de migration (7) du second type de conductivité formée pour être en contact avec la région de corps ;
une région de drain (10) du second type de conductivité formée sur la région de migration ;
une électrode de grille (13) formée sur la région de corps entre la région de source et la région de migration et la région de migration sur le côté de la région de source par l'intermédiaire d'un film isolant de grille (12) ;
une première plaque de champ (13) s'étendant à partir de l'électrode de grille en direction de la région de drain et formée sur la région de migration par l'intermédiaire d'un premier film isolant (8) ;
une seconde plaque de champ (16a, 19a) composée d'une pluralité de couches de câblage, et étant en contact avec la région de source ou l'électrode de grille et formée sur la première plaque de champ par l'intermédiaire d'un second film isolant (14) ;
une première région enfouie (4) du premier type de conductivité en contact avec la région de corps et formée sous la région de migration ; et
une deuxième région enfouie (5) du premier type de conductivité étant adjacente à la première région enfouie et ayant une concentration en impuretés inférieure à la concentration en impuretés de la première région enfouie formée sous la région de migration et s'étendant à partir de la première région enfouie en direction de la région de drain,
dans lequel dans la pluralité de couches de câblage constituant la seconde plaque de champ, une distance entre une couche de câblage supérieure et la région de drain est plus courte qu'une distance entre une couche de câblage inférieure et la région de drain, et une distance entre une couche de câblage tout en bas et la région de drain est plus courte qu'une distance entre la première plaque de champ et la région de drain,
une distance entre une couche de câblage tout en haut et la région de drain est plus courte qu'une distance entre la deuxième région enfouie et la région de drain, et
la distance entre la première plaque de champ et la région de drain est plus longue qu'une distance entre la première région enfouie et la région de drain.

**2.** Dispositif semi-conducteur selon la revendication 1, dans lequel une concentration en impuretés de la région de migration est supérieure à $1e10^{16}/cm^3$, et une concentration en impuretés de la première région enfouie est supérieure à $1e10^{16}/cm^3$, et
la concentration en impuretés de la deuxième région enfouie est établie à une valeur de 1/3 à 2/3 de la concentration en impuretés de la première région enfouie.

**3.** Dispositif semi-conducteur selon la revendication 1 ou 2, dans lequel dans la pluralité de couches de câblage constituant la seconde plaque de champ,
la distance entre la couche de câblage tout en bas et la région de drain est inférieure à la distance entre la première région enfouie et la région de drain, et supérieure à la distance entre la deuxième région enfouie et la région de drain.

**4.** Dispositif semi-conducteur selon la revendication 3, comprenant :

une troisième région enfouie (23) du premier type de conductivité adjacente à la deuxième région enfouie et ayant une concentration en impuretés inférieure à la concentration en impuretés de la deuxième région enfouie formée sous la région de migration et s'étendant à partir de la deuxième région enfouie en direction de la région de drain,
dans lequel une distance entre la troisième région enfouie et la région de drain est supérieure à la distance entre la couche de câblage tout en haut et la région de drain dans les couches de câblage constituant la seconde plaque de champ.

5. Dispositif semi-conducteur selon la revendication 4, dans lequel la concentration en impuretés de la troisième région enfouie est établie à une valeur de 1/3 à 2/3 de la concentration en impuretés de la deuxième région enfouie.

6. Dispositif semi-conducteur selon l'une quelconque des revendications 1 à 5, dans lequel le substrat semi-conducteur comprend un substrat SOI ayant une couche isolante enfouie dans une couche semi-conductrice.

**FIG. 1**

FIG. 2

FIG. 3

100

9     7   8    14    17

19a                                   19b

18a                                   18b

16a                                   16b

15a          13 12                  15b

                                         10

11                                    8

P+ N+                        N+

6   P                    N

P      P

4        5

                                    P−   3

                                       2

                                     P−   1

# FIG. 4

FIG. 5

FIG. 6

FIG. 7

FIG. 8

FIG. 9

FIG. 10

**EP 4 184 590 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020098883 A